Europäisches Patentamt

European Patent Office

Office européen des brevets

(11) Publication number: **0 197 663 B1**

# EUROPEAN PATENT SPECIFICATION

(45) Date of publication of patent specification: **05.08.92**  (51) Int. Cl.⁵: **G11B 5/592**, H04B 17/00, H01L 41/04

(21) Application number: **86301697.8**

(22) Date of filing: **10.03.86**

(54) **Methods of and apparatus for controlling a bimorph distortion detection device.**

(30) Priority: **12.03.85 JP 48688/85**

(43) Date of publication of application:
**15.10.86 Bulletin 86/42**

(45) Publication of the grant of the patent:
**05.08.92 Bulletin 92/32**

(84) Designated Contracting States:
**AT DE FR GB NL**

(56) References cited:
**EP-A- 0 144 719
FR-A- 2 345 050
US-A- 4 172 265
US-A- 4 513 334**

**PATENT ABSTRACTS OF JAPAN, vol. 5, no.
130 (P-76)[802], 20th August 1981; & JP-A-56
68 922 (SONY K.K.) 09-06-1981**

(73) Proprietor: **SONY CORPORATION
7-35 Kitashinagawa 6-chome Shinagawa-ku
Tokyo 141(JP)**

(72) Inventor: **Yoshihiro, Mitsugu Patents Division
Sony Corporation 6-7-35 Kitashinagawa
Shinagawa-ku Tokyo 141(JP)**

(74) Representative: **Thomas, Christopher Hugo et
al
D Young & Co 10 Staple Inn
London WC1V 7RD(GB)**

## Description

This invention relates to methods of and apparatus for controlling a deflectable head. The invention is more particularly, but not exclusively, concerned with controlling a deflectable head of a video tape recorder (VTR), and for reducing secular variation of a bimorph distortion detection device attached to a bimorph leaf carrying the head.

There is known a VTR in which a head chip is attached to one end of a bimorph leaf, the other end of which is fixed. A drive signal is supplied to the bimorph leaf so that even in a variable speed playback mode, a rotary magnetic head can positively scan an oblique track formed on a magnetic tape. For example, a bimorph head tracking technique using so-called wobbling is disclosed in US patent specification US-A-4 229 773, a technique of using a strain gauge to detect the deflection of a bimorph leaf is disclosed in US patent specification US-A-4 172 265, and a technique using a damping AC signal to correct the hysteresis of a bimorph leaf is disclosed in U.S. patent specification US-A-4 513 334.

In a bimorph driving apparatus for a bimorph deflectable head, the bimorph leaf contains in its electro-mechanical transducer characteristic a hysteresis characteristic, and the secular variation of its sensitivity and the variation of the sensitivity with temperature are large. To solve this problem, strain gauges have been attached to both sides of the bimorph leaf, and a distortion or deflection detecting output from the strain gauge is negatively fed back to the driving signal.

However, the offset amount of the distortion or deflection detecting output from the strain gauges attached to the bimorph leaf also has secular variation, so that there is the defect that error occurs in the distortion, displacement or deflection amount of the bimorph deflectable head. Thus, when a damping AC signal is applied to the bimorph leaf, the deflection or distortion of the bimorph leaf becomes zero. Accordingly, it should be appreciated that the signal output from the strain gauge (for example, in practice, a signal generated by change in the resistance value of the strain gauge) becomes of constant value corresponding to the zero distortion or deflection of the bimorph leaf. However, if in the strain gauge itself there is scattering or a secular variation occurs, the signal output from the strain gauge can take various values relative to the zero distortion or deflection of the bimorph leaf and it does not assume the constant value. As a result, the distortion or deflection amount of the bimorph deflectable head is not controlled correctly.

According to the present invention there is provided a bimorph leaf apparatus comprising:

a controllable deflectable head mounted on a bimorph leaf;
a deflection detector means coupled to said bimorph leaf to detect the deflection of said bimorph leaf; and
a drive signal generator for generating a drive signal to deflect said bimorph leaf;
characterized by:
a damping signal generator for generating a damping signal used to reduce distortion of said bimorph leaf;
signal producing means for producing a signal in response to secular variation of said deflection detector means; and
level shifting means for shifting the DC voltage level of the output signal of said signal producing means to a predetermined DC voltage level after said distortion of said bimorph leaf has been reduced by said damping signal;
any subsequent change in the DC voltage level of the output signal of said signal producing means being supplied to a combining means to be combined with said drive signal for supply to said bimorph leaf.

According to the present invention there is also provided a method of reducing secular variation of a bimorph leaf apparatus comprising:

a controllable deflectable head mounted on a bimorph leaf;
deflection detection means coupled to said bimorph leaf to detect the deflection of said bimorph leaf; and
a drive signal generator for generating a drive signal to deflect said bimorph leaf;
the method being characterized by:
generating a damping signal used to reduce distortion of said bimorph leaf;
producing a signal in response to secular variation of said deflection detection means; and
shifting the DC voltage level of said signal produced in response to secular variations to a predetermined DC voltage level after said distortion of said bimorph leaf has been reduced by said damping signal;
any subsequent change in the DC voltage level of said signal produced in response to secular variation being combined with said drive signal for supply to said bimorph leaf.

The invention will now be described by way of example with reference to the accompanying drawings, throughout which like parts are referred to by like references, and in which:

Figure 1 is a block diagram showing an embodiment of apparatus for controlling a deflectable head and according to the present invention;

Figure 2 is a circuit diagram showing one example of a resistor bridge circuit used in the embodiment of Figure 1; and

Figure 3 is a flow chart for explaining the operation of the embodiment of Figure 1.

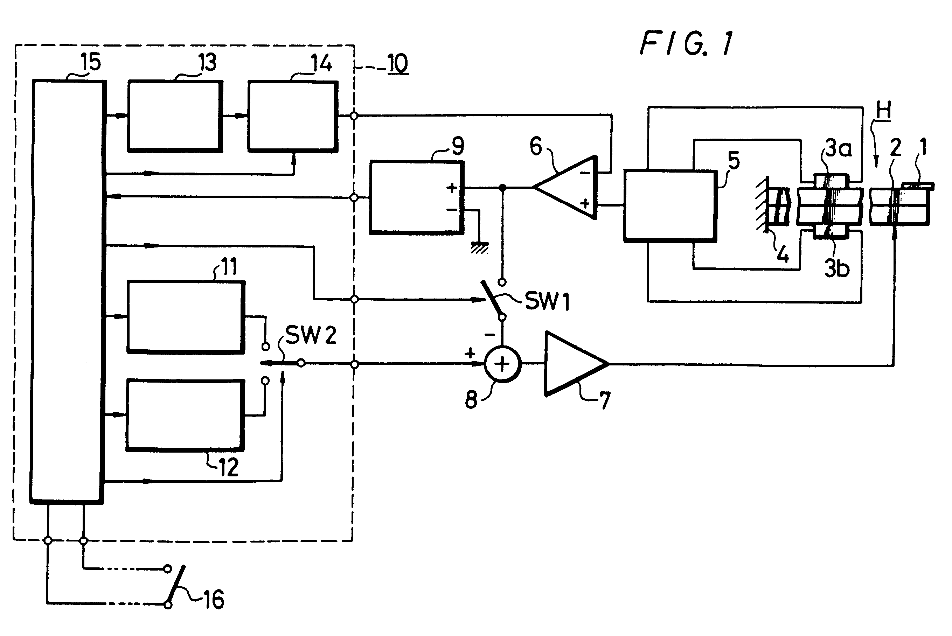

Referring to Figure 1, a bimorph deflectable head H comprises a head (head chip) 1 forming the or one of a plurality of rotary magnetic heads (bimorph heads) mounted on a tape guide drum of a VTR. The head 1 is attached to one end of a bimorph leaf 2. The other end of the bimorph leaf 2 is fixed to a fixed portion (a part of the rotary drum) 4, and the head 1 can be deflected or displaced by the bimorph leaf 2 in the direction substantially perpendicular to its tracing or scanning direction. On the flexible surfaces of the bimorph leaf 2, there are bonded strain gauges 3a and 3b, respectively.

A resistor bridge circuit 5 has the strain gauges 3a and 3b in two arms, and generates a difference output between the outputs of the strain gauges 3a and 3b, that is, a distortion detecting output.

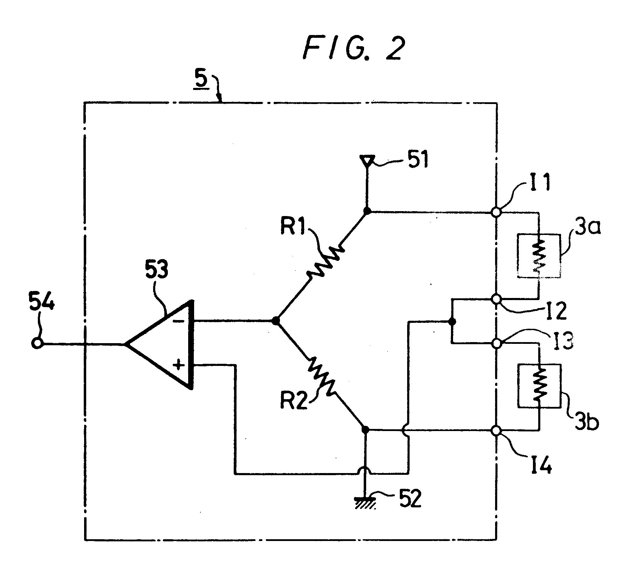

As Figure 2 shows, the resistor bridge circuit 5 also comprises two resistors R1 and R2 connected in series between a power source terminal 51 and earth 52. The connection point between the resistors R1 and R2 is connected to the inverting input terminal of a differential amplifier 53. The resistor bridge circuit 5 further includes input terminals 11 and 12, and 13 and 14 which are connected to the respective ends of the strain gauges 3a and 3b. The input terminals 12 and 13 are connected together, and are further connected to the non-inverting input terminal of the differential amplifier 53. Accordingly, at an output terminal 54 of the resistor bridge circuit 5 connected to the output of the differential amplifier 53, there is developed a difference voltage between the voltage corresponding to the ratio of the resistance values of the resistors R1 and R2 and the voltage corresponding to the ratio of the resistance values of the strain gauges 3a and 3b, namely, a distortion detection output.

Turning back to Figure 1, a differential amplifier 6 is supplied at one input terminal with the distortion detection output from the resistor bridge circuit 5, and at the other input terminal with an output from a bias voltage generating means 13 via a voltage holding means 14.

The output from the differential amplifier 6 is supplied, when the distortion of the bimorph leaf 2 is to be erased, to a comparator circuit 9 in which it is compared with a zero voltage. A drive amplifier 7 is arranged to supply the drive signal to the bimorph leaf 2, and a composer 8 is provided at the input side of the drive amplifier 7. When the bimorph leaf 2 is driven in the normal mode, the composer 8 is supplied with a drive signal (a sawtooth wave signal) from a drive signal generating means 11 which will be described later, and is also supplied with the output from the differential amplifier 6 through a switch SW1. Thus, in the composer 8, the latter output is subtracted from the drive signal from the drive signal generating means 11. Then, the subtracted output from the composer 8 is supplied to the bimorph leaf 2 via the drive amplifier 7.

A microprocessor 10 comprises the drive signal generating means 11, a damping signal generating means 12, the bias voltage generating means 13 and the voltage holding means 14, a control means 15 and a change-over switch SW2. The voltage holding means 14 is arranged to hold a bias voltage supplied thereto from the bias voltage generating means 13. The bias voltage generating means 13 and the voltage holding means 14 are controlled by the control means 15. The output from the comparator circuit 9 is supplied to the control means 15. The drive signal from the drive signal generating means 11 and the damping signal from the damping signal generating means 12 are switched by the change-over switch SW2, and then fed to the composer 8. Also, the signal generating means 11 and 12 and the change-over switches SW1 and SW2 are controlled by the control means 15.

A switch 16 is arranged to be temporarily turned on, for example, when a tape cassette is loaded onto the cassette compartment of the VTR. From the switch 16, a detection signal indicative of the loading of the tape cassette onto the VTR is supplied to the control means 15 in the microprocessor 10. The switch 16 may be a manual switch or timer switch which is capable of being turned on say once every day or once every two days. Although the secular variation of the distortion of the strain gauge is as small as $1 \times 10^{-6}$ m (1 micron) per day, if such secular variation is accumulated over a period of several days or more, such accumulated secular variation cannot be neglected.

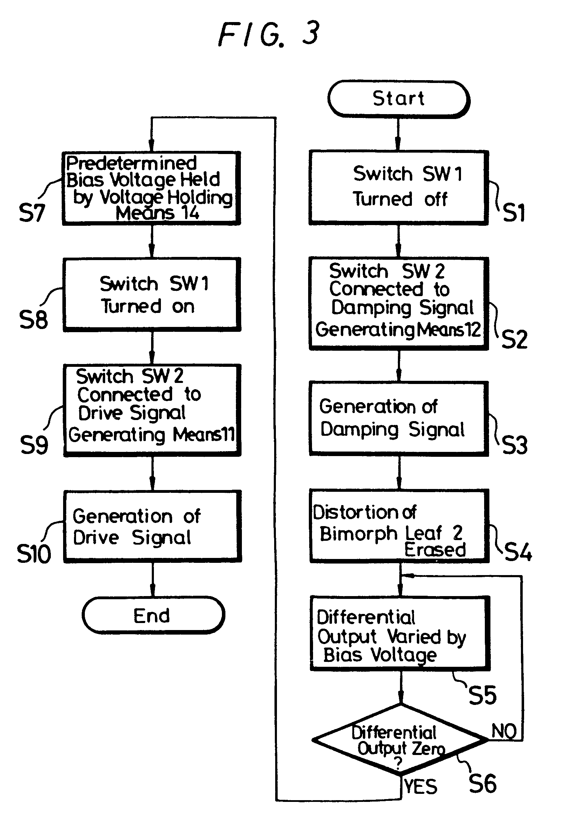

The operation of the embodiment will now be described with reference to the flow chart of Figure 3. When the tape cassette is loaded onto the VTR, the switch 16 is temporarily turned on, so that the loading of the tape cassette onto the VTR is detected by the control means 15 in the microprocessor 10. Then the control means 15 controls the change-over switch SW1 to turn off (at step S1) and the movable contact of the change-over switch SW2 is switchably connected to the damping signal generating means 12 (at step S2). As a result, the damping signal is generated from the damping signal generating means 12 (at step S3) on the basis of the control means 15, and then fed to the bimorph leaf 2 via the change-over switch SW2, the composer 8 and the drive amplifier 7 during a predetermined period, and thereby the distortion of the bimorph leaf 2 is erased (at step S4). After the erasure of the distortion of the bimorph leaf 2 has finished, the distortion detection output detected by the resistor bridge circuit 5 is supplied to one input terminal of the differential amplifier 6. The output from the differential amplifier 6 is supplied to the comparing circuit 9 in which it is compared with the zero voltage. The compared output from the comparing circuit 9 is supplied to the control means 15. On the basis of the compared output supplied thereto, the control means 15 controls the bias voltage generating means 13 (at step S5) to supply to the other input terminal of the differential amplifier 6 a bias voltage which makes the output voltage from the differential amplifier 6 become zero voltage. When the output voltage from the differential amplifier 6 becomes zero (at step S6), the predetermined bias voltage at that time is held by the voltage holding means 14 (at step S7) and then the voltage held is fed to the other input terminal of the differential amplifier 6. However, when the output from the differential amplifier 6 is not zero, the routine is returned to the step S5 and the bias voltage generating means 13 is controlled by the control means 15. Then, the above operation is carried out until the output from the differential amplifier 6 becomes zero. Thereafter, the control means 15 controls the switch SW1 to turn on (at step S8) and the switch SW2 to change in position to the side of the drive signal generating means 11 (at step S9) so that the drive signal generating means 11 is controlled by the control means 15 so as to generate a drive signal having an initial deflection amount, frequency and inclination level corresponding to the running speed of the magnetic tape (at step S10). This drive signal is supplied via the change-over switch SW2 to the composer 8 in which the output from the differential amplifier 6 is subtracted from the same. The subtracted output from the composer 8 is supplied via the drive amplifier 7 to the bimorph leaf 2 so that the bimorph leaf 2 is driven to enable the head 1 positively to scan the oblique track formed on the magnetic tape.

Thus with the embodiment it is possible to remove the delay of the response speed of the bimorph leaf caused by the hysteresis characteristics of its electro-mechanical transducer characteristic, the secular variation of its sensitivity, the change of its sensitivity with change of temperature, and so on. Moreover, it is possible to remove the error of the displacement or deflection amount in the direction substantially perpendicular to the head scanning direction, caused by the secular variation of the offset amount of the distortion detection output from the strain gauge.

## Claims

1. A bimorph leaf apparatus comprising:
   a controllable deflectable head (1) mounted on a bimorph leaf (2);
   a deflection detector means (3a, 3b) coupled to said bimorph leaf (2) to detect the deflection of said bimorph leaf (2); and
   a drive signal generator (11) for generating a drive signal to deflect said bimorph leaf (2);
   characterized by:
   a damping signal generator (12) for generating a damping signal used to reduce distortion of said bimorph leaf (2);
   signal producing means (5) for producing a signal in response to secular variation of said deflection detector means (3a, 3b); and
   level shifting means (13, 14, 6) for shifting the DC voltage level of the output signal of said signal producing means (5) to a predetermined DC voltage level after said distortion of said bimorph leaf (2) has been reduced by said damping signal;
   any subsequent change in the DC voltage level of the output signal of said signal producing means (5) being supplied to a combining means (8) to be combined with said drive signal for supply to said bimorph leaf (2).

2. Apparatus according to claim 1 wherein said deflection detector means (3a, 3b) is a pair of strain gauges (3a, 3b).

3. Apparatus according to claim 2 wherein said strain gauges (3a, 3b) are attached on respective sides of said bimorph leaf (2).

4. Apparatus according to claim 3 wherein said signal producing means (5) includes a resistor bridge circuit (5).

5. Apparatus according to claim 4 wherein said level shifting means (13, 14, 6) includes a bias voltage signal generating circuit (13) for generating a bias voltage signal and a differential amplifier (6) supplied with said bias voltage signal and an output signal of said resistor bridge circuit (5), so that a DC voltage level of an output signal of said differential amplifier (6) becomes said predetermined DC voltage level.

6. Apparatus according to claim 5 wherein said bias voltage signal generating circuit (13) includes a comparator (9) for comparing said DC voltage level of said output signal of said differential amplifier (6) with said predetermined DC voltage level, a bias voltage signal generator (13) for generating a bias voltage signal in response to an output signal of said comparator (9) and a hold circuit (14) for holding an output signal from said bias voltage signal generator (13).

**7.** Apparatus according to claim 6 wherein said predetermined DC level is a zero voltage level.

**8.** Apparatus according to claim 7 wherein said resistor bridge circuit (5) includes serially-connected-resistors connected between common voltage sources (51, 52), connecting lines for connecting said pair of strain gauges (3a, 3b) in series between said common voltage sources (51, 52), and a differential circuit (53) the two input terminals of which are respectively connected to a junction of said serially-connected-strain gauges (3a,3b) and a junction of said serially-connected-resistors (R1, R2).

**9.** A method of reducing secular variation of a bimorph leaf apparatus comprising:

a controllable deflectable head (1) mounted on a bimorph leaf (2);

deflection detector means (3a, 3b) coupled to said bimorph leaf (2) to detect the deflection of said bimorph leaf (2); and

a drive signal generator (11) for generating a drive signal to deflect said bimorph leaf (2);

the method being characterized by:

generating a damping signal used to reduce distortion of said bimorph leaf (2);

producing a signal in response to secular variation of said deflection detection means (3a, 3b); and

shifting the DC voltage level of said signal produced in response to secular variations to a predetermined DC voltage level after said distortion of said bimorph leaf (2) has been reduced by said damping signal;

any subsequent change in the DC voltage level of said signal produced in response to secular variation being combined with said drive signal for supply to said bimorph leaf (2).

**Revendications**

**1.** Appareil à lame bimorphe, comprenant:

une tête (1) à montage fléchissant, pouvant être contrôlé, montée sur une lame bimorphe (2);

un moyen (3a, 3b) détecteur de déviation couplé à la lame bimorphe (2) pour détecter la déviation de cette lame (2); et

un générateur (11) de signaux d'excitation pour générer un signal d'excitation destiné à dévier la lame bimorphe (2);

caractérisé par:

un générateur (12) de signaux amortisseurs pour générer un signal amortisseur utilisé pour réduire la distorsion de la lame bimorphe (2);

un moyen (5) de production de signaux pour produire un signal en réponse à une variation à long terme du moyen (3a, 3b) détecteur de déviation; et

un moyen (13, 14, 6) de décalage de niveau pour décaler le niveau de la tension continue du signal de sortie du moyen (5) de production de signaux à un niveau de tension continue prédéterminé, après que la distorsion de la lame bimorphe (2) a été réduite par le signal amortisseur;

tout changement consécutif du niveau de la tension continue du signal de sortie du moyen (5) de production de signaux étant appliqué à un moyen de combinaison (8) pour être combiné au signal d'excitation en vue de l'application à la lame bimorphe (2).

**2.** Appareil selon la revendication 1, dans lequel le moyen détecteur de déviation (3a, 3b) est une paire de jauges de contrainte (3a, 3b).

**3.** Appareil selon la revendication 2, dans lequel les jauges de contrainte (3a, 3b) sont attachées à des côtés respectifs de la lame bimorphe (2).

**4.** Appareil selon la revendication 3, dans lequel le moyen de production de signaux (5) comporte un circuit de résistances en pont (5).

**5.** Appareil selon la revendication 4, dans lequel le moyen de décalage de niveau (13, 14, 6) comporte un circuit (13) générateur de signaux de tension de polarisation, destiné à générer un signal de tension de polarisation, ainsi qu'un amplificateur différentiel (6) alimenté avec ce signal de tension de polarisation et un signal de sortie du circuit de résistances en pont (5), de manière que le niveau de tension continue du signal de sortie de l'amplificateur différentiel (6) devienne le niveau de tension continue prédéterminé.

**6.** Appareil selon la revendication 5, dans lequel le circuit (13) générateur de signaux de tension de polarisation comporte un comparateur (9) pour comparer le niveau de tension continue du signal de sortie de l'amplificateur différentiel (6) avec le niveau de tension continue prédéterminé, un générateur (13) de signaux de tension de polarisation pour générer un signal de tension de polarisation en réponse a un signal de sortie du comparateur (9), ainsi qu'un circuit de maintien (14) pour maintenir un signal de sortie de ce générateur (13) de signaux de tension de polarisation.

**7.** Appareil selon la revendication 6, dans lequel le niveau de tension continue prédéterminé est un niveau de tension nulle.

8. Appareil selon la revendication 7, dans lequel le circuit de résistances en pont (5) comporte des résistances connectées en série entre des sources (51, 52) d'alimentation communes, des lignes de liaison pour connecter la paire de jauges de contrainte (3a, 3b) en série entre ces sources (51, 52) de tension communes et un circuit différentiel (53) dont les deux bornes d'entrée sont respectivement connectées à une jonction des jauges de contrainte (3a, 3b) connectées en série et une jonction des résistances (R1, R2) connectées en série.

9. Procédé pour réduire la variation à long terme d'un appareil à lame bimorphe, comprenant:
une tête (1) à montage fléchissant, pouvant être contrôlé, montée sur une lame bimorphe;
un moyen (3a, 3b) détecteur de déviation couplé à la lame bimorphe (2) pour détecter la déviation de cette lame (2); et
un générateur (11) de signaux d'excitation pour générer un signal d'excitation destiné à dévier la lame bimorphe (2);
le procédé étant caractérisé en ce qu'il comprend:
la génération d'un signal amortisseur utilisé pour réduire la distorsion de la lame bimorphe (2);
la production d'un signal en réponse à une variation à long terme du moyen détecteur de déviation (3a, 3b); et
le décalage du niveau de la tension continue du signal, produit en réponse à des variations à long terme, à un niveau de tension continue prédéterminé après que la distorsion de la lame bimorphe (2) a été réduite par le signal amortisseur;
tout changement consécutif du niveau de tension continue du signal, produit en réponse à une variation à long terme, étant combiné avec le signal d'excitation en vue de l'application à la lame bimorphe (2).

**Patentansprüche**

1. Zweielementblatt-Vorrichtung mit einem steuerbaren auslenkbaren Kopf (1), der an einem Zweielementblatt (2) angebracht ist,
mit einer mit dem Zweielementblatt (2) gekoppelten Auslenk-Detektoreinrichtung (3a, 3b) zur Ermittelung der Auslenkung des betreffenden Zweielementblattes (2) und mit einem Treibersignalgenerator (11) für die Erzeugung eines Treibersignals zur Auslenkung des betreffenden Zweielementblattes (2),
**dadurch gekennzeichnet,**
daß ein Dämpfungssignalgenerator (12) für die Erzeugung eines Dämpfungssignals vorgesehen ist, welches zur Herabsetzung der Verzerrung des betreffenden Zweielementblattes (2) dient,
daß eine Signalerzeugungseinrichtung (5) vorgesehen ist, die auf eine eine Säkularvariation der genannten Auslenk-Detektoreinrichtung (3a, 3b) hin ein Signal erzeugt,
und daß eine Pegelverschiebeinrichtung (13,14,6) vorgesehen ist, die den Gleichspannungspegel des Ausgangssignals der Signalerzeugungseinrichtung (5) auf einen bestimmten Gleichspannungspegel verschiebt, nachdem die Verzerrung des Zweielementblatts (2) durch das Dämpfungssignal herabgesetzt worden ist,
wobei jegliche nachfolgende Änderung im Gleichspannungspegel des Ausgangssignals der Signalerzeugungseinrichtung (5) einer Zusammenfassungseinrichtung (8) zugeführt wird, in der diese mit dem Treibersignal für die Zuführung zu dem Zweielementblatt (2) zusammengefaßt wird.

2. Vorrichtung nach Anspruch 1, wobei die genannte Ablenk-Detektoreinrichtung (3a, 3b) durch ein Paar von Dehnungsmeßstreifen (3a, 3b) gebildet ist.

3. Vorrichtung nach Anspruch 2, wobei die Dehnungsmeßstreifen (3a, 3b) an entsprechenden Seiten des Zweielementblattes (2) angebracht sind.

4. Vorrichtung nach Anspruch 3, wobei die Signalerzeugungseinrichtung (5) eine Widerstands-Brückenschaltung (5) aufweist.

5. Vorrichtung nach Anspruch 4, wobei die Pegelverschiebeinrichtung (13, 14, 6) eine Vorspannungssignalerzeugungsschaltung (13) für die Erzeugung eines Vorspannungssignals und einen Differenzverstärker (6) umfaßt, dem das betreffende Vorspannungssignal und ein Ausgangssignal der Widerstands-Brückenschaltung (5) zugeführt werden, derart, daß ein Gleichspannungspegel eines Ausgangssignals des betreffenden Differenzverstärkers (6) der bestimmte Gleichspannungspegel wird.

6. Vorrichtung nach Anspruch 5, wobei die Vorspannungssignalerzeugungsschaltung (13) einen Komparator (9) für einen Vergleich des Gleichspannungspegels des Ausgangssignals des Differenzverstärkers (6) mit dem bestimmten Gleichspannungspegel, einen Vorspannungssignalgenerator (13) für die Erzeugung eines Vorspannungssignals auf ein Ausgangssignal des betreffenden Komparators (9) hin und eine Halteschaltung (14) aufweist, die ein Ausgangssignal von dem Vorspannungssignalgenerator (13) her festhält.

7. Vorrichtung nach Anspruch 6, wobei der bestimmte Gleichspannungspegel ein Null-Spannungspegel ist.

8. Vorrichtung nach Anspruch 7, wobei die Widerstands-Brückenschaltung (5) zwischen gemeinsamen Spannungsquellen (51, 52) in Reihe geschaltete Widerstände aufweist, wobei durch Verbindungsleitungen das genannte Paar der Dehnungsmeßstreifen (3a, 3b) in Reihe zwischen den gemeinsamen Spannungsquellen (51, 52) angeschlossen ist und wobei eine Differenzschaltung (53) mit zwei Eingangsanschlüssen vorgesehen ist, die nit einem Verbindungspunkt der in Reihe geschalteten Dehnungsmeßstreifen (3a, 3b) bzw. mit einem Verbindungspunkt der in Reihe geschalteten Widerstände (R1, R2) verbunden sind.

9. Verfahren zur Herabsetzung der Säkularvariation einer Zweielementblatt-Vorrichtung, umfassend einen steuerbaren auslenkbaren Kopf (1), der an einem Zweielementblatt (2) angebracht ist, eine Auslenk-Detektoreinrichtung (3a, 3b), die mit dem betreffenden Zweielementblatt (2) derart gekoppelt ist, daß die Auslenkung des betreffenden Zweielementblattes (2) ermittelt wird, und einen Treibersignalgenerator (11) für die Erzeugung eines Treibersignals zur Auslenkung des genannten Zweielementblattes (2),

**dadurch gekennzeichnet,**

daß ein Dämpfungssignal erzeugt wird, welches zur Herabsetzung der Verzerrung des Zweielementblattes (2) herangezogen wird,

daß auf die Säkularvariation der Auslenk-Detektoreinrichtung (3a, 3b) hin ein Signal erzeugt wird

und daß der Gleichspannungspegel des auf Säkularvariationen hin erzeugten Signals zu einen bestimmten Gleichspannungspegel verschoben wird, nachdem die Verzerrung des Zweielementblattes (2) durch das genannte Dämpfungssignal herabgesetzt worden ist,

wobei jede anschließende Änderung im Gleichspannungspegel des auf die Säkularvariation hin erzeugten Signals mit dem Treibersignal für die Zuführung zu dem Zweielementblatt (2) kombiniert wird.

*FIG. 1*

# FIG. 2

# FIG. 3

```
                                              ┌──────────┐
                                              │  Start   │
                                              └────┬─────┘
                                                   │
                                                   ▼
┌─────────────────────┐              ┌─────────────────────┐
│ Predetermined       │              │   Switch SW1        │
│ Bias Voltage Held   │              │   Turned off        │
│ by Voltage Holding  │          S1  │                     │
│ Means 14            │              └──────────┬──────────┘
└──────────┬──────────┘  S7                     │
           │                                     ▼
           ▼                        ┌─────────────────────┐
┌─────────────────────┐             │   Switch SW2        │
│   Switch SW1        │             │   Connected to      │
│   Turned on         │             │   Damping Signal    │
│                     │             │   Generating Means12 │  S2
└──────────┬──────────┘  S8         └──────────┬──────────┘
           │                                     │
           ▼                                     ▼
┌─────────────────────┐             ┌─────────────────────┐
│   Switch SW2        │             │   Generation of     │
│   Connected to      │             │   Damping Signal    │
│   Drive Signal      │             │                     │  S3
│   Generating Means11 │  S9         └──────────┬──────────┘
└──────────┬──────────┘                         │
           │                                     ▼
           ▼                        ┌─────────────────────┐
┌─────────────────────┐             │ Distortion of       │
│   Generation of     │             │ Bimorph Leaf 2      │
│   Drive Signal      │             │ Erased              │  S4
│                     │  S10        └──────────┬──────────┘
└──────────┬──────────┘                         ▼
           │                        ┌─────────────────────┐
           ▼                        │ Differential        │
     ┌──────────┐                   │ Output Varied by    │
     │   End    │                   │ Bias Voltage        │  S5
     └──────────┘                   └──────────┬──────────┘
                                                │
                                                ▼
                                          ◇ Differential ◇   NO
                                          ◇ Output Zero ◇ ────┐
                                          ◇     ?      ◇  S6
                                               │ YES
```